Europäisches Patentamt

European Patent Office

Office européen des brevets

(11) Veröffentlichungsnummer: **0 243 317**
A2

(12) # EUROPÄISCHE PATENTANMELDUNG

(21) Anmeldenummer: 87810246.6

(22) Anmeldetag: 21.04.87

(51) Int. Cl.⁴: **H 03 K 17/94**

(30) Priorität: 23.04.86 CH 1652/86

(43) Veröffentlichungstag der Anmeldung:
28.10.87 Patentblatt 87/44

(84) Benannte Vertragsstaaten:
AT CH DE ES FR GB IT LI NL SE

(71) Anmelder: **Sibalco, W. Siegrist & Co. AG**
**Birmannsgasse 8**
**CH-4055 Basel (CH)**

(72) Erfinder: **Dietrich, Albert**
**c/o Sibalco W. Siegrist & Co. AG Birmannsgasse 8**
**CH-4009 Basel (CH)**

(74) Vertreter: **White, William et al**
**Isler AG Patentanwalts-Bureau Walchestrasse 23**
**CH-8006 Zürich (CH)**

(54) Optokoppler.

(57) Ein Gehäuse (1) weist eingangsseitige (2) und ausgangsseitige (3) Anschlussstifte auf. Im Gehäuse (1) ist eine edelgasgefüllte Glimmlampe (5) angeordnet, die über einen hochohmigen Widerstand (6) mit den eingangsseitigen Anschlussstiften (2) verbunden ist. In einem elektrisch isolierenden Abstand von der Glimmlampe (5) ist im Gehäuse (1) ein lichtempfindliches Festkörperelement (7) angeordnet, das mit den ausgangsseitigen Anschlussstiften (3) verbunden ist. Unter Aussparung eines Lichtweges zwischen der Glimmlampe (5) und dem Festkörperelement (7), beispielsweise mittels eines lichtleitenden optischen Elements (10), ist das Gehäuse (1) lichtundurchlässig verschlossen. Dieser Optokoppler kann zu seiner Steuerung direkt an eine schaltbare Netzwechselspannung angeschlossen werden und weist bei hoher Spannungsfestigkeit eine minimale Verlustleistung auf.

FIG. 1

EP 0 243 317 A2

**Beschreibung**

## Optokoppler

Die Erfindung bezieht sich auf einen Optokoppler gemäss dem Oberbegriff des Patentanspruchs 1.

Optokoppler dieser Art sind in zahlreichen Ausführungsformen bekannt, wobei als schaltbare Lichtquelle eine Glühlampe bzw. ein Infrarot-Licht emittierendes Element oder eine lichtemittierende Diode (LED) und als Lichtempfänger ein Festkörperelement (Photo-Widerstand, Photo-Diode, Photo-Transistor) im Gehäuse angeordnet sind. Eine Glühlampe hat den Nachteil eines beträchtlichen Stromkonsums und einer dadurch hervorgerufenen beträchtlichen Erwärmung. Bei Verwendung einer lichtemittierenden Diode als Lichtquelle sind diese Nachteile zwar weitgehend vermieden. Jedoch müssen sowohl eine Glühlampe als auch eine lichtemittierende Diode mit einer niedrigen Speisespannung von etwa 3V bis höchstens 32V betrieben werden.

Dies bedingt, dass ausserhalb des Optokopplers ein Transformator oder ein verhältnismässig hoch belasteter Widerstand vorgeschaltet werden muss. Bei Verwendung einer lichtemittierenden Diode als Lichtquelle ist es zudem erforderlich, eine externe Gleichrichterschaltung vorzusehen, falls die schaltbare Speisung aus einem Wechselstromnetz erfolgt.

Aufgabe der vorliegenden Erfindung ist, einen Optokoppler der eingangs genannten Art zu schaffen, welcher zur Erzeugung eines Schaltsignals direkt und ohne übermässige Erwärmung an eine schaltbare und/oder modulierbare Gleich- oder Wechselspannung anschliessbar ist.

Die erfindungsgemässe Lösung dieser Aufgabe besteht darin, dass die Lichtquelle eine Glimmlampe ist.

Derartige, als Glimmlampen mit Edelgasfüllung handelsübliche Gasentladungslampen benötigen einen nur sehr kleinen Betriebsstrom. Deshalb kann ein bei Anschluss an eine Gleich- oder Wechselspannung zur Stabilisierung der Entladung bzw. zur Strombegrenzung erforderlicher Vorschaltwiderstand in Reihe zur Glimmlampe in einem Gehäuse des Optokopplers oder im Sockelteil der Glimmlampe angeordnet werden, ohne dass eine übermässige Verlustenergie und eine entsprechend hohe Erwärmung des Optokopplers in Kauf genommen werden müsste. Unter der Bezeichnung "Glimmlampe" ist im übrigen auch eine fluoreszierende Gasentladungslampe zu verstehen.

Ein Ausführungsbeispiel des erfindungsgemässen Optokopplers und zwei Anwendungsvarianten werden nachstehend anhand der Zeichnung erläutert, in welcher

Fig. 1 eine schematische Darstellung des Optokopplers zeigt, und

Fig. 2 und Fig. 3 je ein Blockschema eines mit einer modulierten Spannung gesteuerten Optokopplers zeigen.

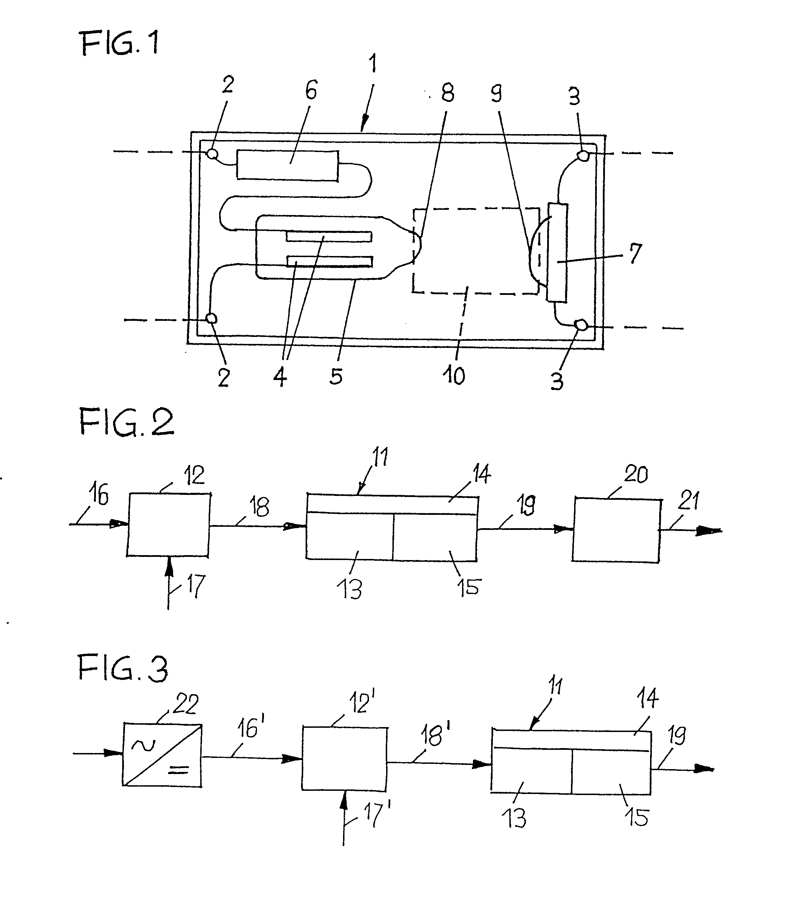

Die Figur 1 zeigt ein einseitig offenes Gehäuse 1 kleiner Abmessungen von beispielsweise 18 mm Länge, 10 mm Breite und 8 mm Tiefe, das zum Beispiel aus einem Kunststoff besteht. Das Gehäuse 1 ist, wie nachfolgend noch erwähnt, mit vier über die offene Gehäuseseite vorragenden Anschlussstiften 2 und 3 versehen, von welchen die Anschlussstifte 2 als Eingangsanschlüsse und die Anschlussstifte 3 als Ausgangsanschlüsse des Optokopplers vorgesehen sind.

An die eingangsseitigen Anschlussstifte 2 sind im Innern des Gehäuses 1 die Elektroden 4 einer edelgasgefüllten Zwerg-Glimmlampe 5 angeschlossen, wie sie handelsüblich ist. In die Zuleitung der einen Elektrode 4 ist ein im allgemeinen hochohmiger Widerstand 6 geschaltet.

In Längsrichtung des Gehäuses 1 ist in einem Abstand von der Glimmlampe 5 ein als Empfänger für das bei Steuerung der Glimmlampe 5 mit Gleich- oder Wechselstrom austretende Licht wirkendes lichtempfindliches Festkörperelement 7 an geordnet, das z.B. ein Photo-Widerstand oder eine Photodiode oder ein Photo-Thyristor sein kann. Das Festkörperelement 7 ist an die ausgangsseitigen Anschlussstifte 3 angeschlossen; wenn als Festkörperelement 7 ein Photo-Transistor angeordnet wird, so kann das Gehäuse 1 mit drei ausgangsseitigen Anschlussstiften zur Verbindung mit diesem Photo-Transistor versehen werden.

Die mit den Anschlussstiften 2 und 3 verbundenen Bauteile, nämlich die Glimmlampe 5 mit dem Vorwiderstand 6 und das lichtempfindliche Festkörperelement 7 sind in das Gehäuse 1 eingelegt, wobei das Lichtaustrittsende 8 der Glimmlampe 5 auf die lichtempfindliche Fläche 9 des Festkörperelements direkt oder indirekt ausgerichtet wird. Das Gehäuse 1 kann hierauf mit einer lichtundurchlässigen, aushärtenden Isoliermasse ausgegossen oder mit einer Platte lichtdicht verschlossen werden. Im Falle des Vergiessens muss selbstverständlich ein Lichtweg zwischen dem Lichtaustrittsende 8 der Glimmlampe 5 und der lichtempfindlichen Fläche 9 des Festkörperelements 8 ausgespart bleiben, beispielsweise mittels einer aus einem elektrisch isolierenden Material bestehenden Hülse oder einer ähnlichen Abdeckung. Vorteilhaft kann es sein, zwischen dem Lichtaustrittsende 8 der Glimmlampe 5 und der lichtempfindlichen Fläche 9 des Festkörperelements 8 einen Lichtleiter 10 z.B. aus Glas oder lichtleitenden Fasern anzuordnen, wie dies in der Figur gestrichelt angedeutet ist.

Zur Steuerung der Glimmlampe 5 mit Wechselstrom kann an die eingangsseitigen Anschlussstifte 2 direkt eine ein- und ausschaltbare Wechselspannung gelegt werden, wobei der Wert des Vorwiderstandes 6 entsprechend der für den Betrieb vorgesehenen, angelegten Wechselspannung sowie der Zündspannung zu bestimmen ist. Da der Stromverbrauch der Glimmlampe 5 minimal ist, nämlich etwa 0,2 bis 0,3 mA, ist der Energieverbrauch sowohl der Glimmlampe 5, als auch des den Strom bei gezündeter Glimmlampe begrenzenden Vorwiderstandes 6 sehr klein, so dass keine unerwünschte Erwärmung des fertigen Optokopplers auftritt. Bei einer steuernden Wechselspannung von 220 V sind diese Verluste in der Grössenordnung steuert die Glimmlampe 13 des Optokopplers 11. Ein entsprechendes tonfrequentes Signal liegt dann auf der Ausgangsleitung 19 des Optokopplers 11, das naturgemäss keiner Demodulation wie im Beispiel der Fig. 2 unterworfen werden muss.

**Patentansprüche**

1. Optokoppler mit einer elektrisch steuerbaren Lichtquelle und mit einem der Lichtquelle zugeordneten, von dieser elektrisch isolierten Lichtempfänger, wobei die Lichtquelle und der Lichtempfänger bezüglich Umgebungslicht abgeschirmt sind, dadurch gekennzeichnet, dass die Lichtquelle eine Glimmlampe ist.

2. Optokoppler nach Anspruch 1, dadurch gekennzeichnet, dass in Reihe zur Glimmlampe ein Vorwiderstand geschaltet ist, um eine direkte Steuerung der Glimmlampe mittels einer ein- und ausschaltbaren und/oder modulierbaren Gleich- oder Wechselspannungsquelle zu ermöglichen.

3. Optokoppler nach Anspruch 1 oder 2, dadurch gekennzeichnet, dass der Lichtempfänger ein lichtempfindliches Festkörperelement ist, zum Beispiel ein Photo-Widerstand, eine Photo-Diode, ein Photo-Transistor oder ein Photo-Thyristor.

4. Optokoppler nach einem der Ansprüche 1 bis 3, dadurch gekennzeichnet, dass zwischen der Lichtquelle und dem Lichtempfänger ein elektrisch isolierendes optisches Element angeordnet oder ein Lichtweg ausgespart ist, um einen Teil des Lichtes der Lichtquelle auf den Lichtempfänger zu leiten.

5. Schaltungsanordnung mit einem Optokoppler gemäss einem der Patentansprüche 1 bis 4, dadurch gekennzeichnet, dass zwischen einer Steuerspannungsquelle und dem Optokoppler ein Modulator geschaltet ist, welchem ein tonfrequentes Modulationssignal zuführbar ist.

6. Schaltungsanordnung nach Anspruch 5, bei welcher die Steuerspannungsquelle eine Wechselspannungsquelle ist, dadurch gekennzeichnet, dass an den Ausgang des Optokopplers ein Demodulator angeschlossen ist.

7. Schaltungsanordnung nach Anspruch 5, bei welcher die Steuerspannungsquelle eine Wechselspannungsquelle ist, dadurch gekennzeichnet, dass zwischen der Wechselspannungsquelle und dem Modulator ein Gleichrichter geschaltet ist.

0243317

# FIG.1

# FIG.2

# FIG.3